(19) Europäisches Patentamt / European Patent Office / Office européen des brevets

(11) **EP 2 819 152 A1**

(12) **EUROPEAN PATENT APPLICATION**
published in accordance with Art. 153(4) EPC

(43) Date of publication:
**31.12.2014 Bulletin 2015/01**

(21) Application number: **12869179.7**

(22) Date of filing: **04.12.2012**

(51) Int Cl.:
*H01L 21/338* (2006.01)   *H01L 21/205* (2006.01)
*H01L 29/778* (2006.01)   *H01L 29/812* (2006.01)

(86) International application number:
**PCT/JP2012/081363**

(87) International publication number:
**WO 2013/125126 (29.08.2013 Gazette 2013/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.02.2012 JP 2012037444**

(71) Applicant: **NGK Insulators, Ltd.
Nagoya-shi, Aichi 467-8530 (JP)**

(72) Inventors:
• **SUGIYAMA Tomohiko
Nagoya-shi
Aichi 467-8530 (JP)**

• **SUMIYA Shigeaki
Nagoya-shi
Aichi 467-8530 (JP)**
• **MAEHARA Sota
Nagoya-shi
Aichi 467-8530 (JP)**
• **TANAKA Mitsuhiro
Tsukuba-shi
Ibaraki 305-0821 (JP)**

(74) Representative: **TBK
Bavariaring 4-6
80336 München (DE)**

(54) **SEMICONDUCTOR ELEMENT AND METHOD FOR MANUFACTURING SEMICONDUCTOR ELEMENT**

(57)    Provided is a lattice-matched HEMT device, which is a HEMT device having high reverse breakdown voltage while securing two-dimensional electron gas concentration in a practical range. In producing a semiconductor device by forming a channel layer made of GaN on a base substrate such as an AlN template substrate or a substrate that includes a Si single crystal base material as a base, forming a barrier layer made of a group-III nitride having a composition of $In_xAl_yGa_zN$ ($x+y+z=1$, $0 \leq z \leq 0.3$) on the channel layer, and forming a source electrode, a drain electrode, and a gate electrode on the barrier layer, an In mole fraction $x$, a Ga mole fraction $z$, and a thickness $d$ of the barrier layer satisfy a predetermined range.

FIG. 2

**Description**

Technical Field

The present invention relates to a semiconductor device, and particularly to a semiconductor device that has a Schottky diode junction between a multilayer epitaxial substrate made of a group-III nitride and a metal electrode.

Background Art

Nitride semiconductors, which have high breakdown electric field and high saturation electron velocity, are attracting attention as semiconductor materials for the next-generation high-frequency/high-power devices. For example, a high electron mobility transistor (HEMT) device including a laminate of a barrier layer made of AlGaN and a channel layer made of GaN has a feature that a high-concentration two-dimensional electron gas (2DEG) is generated at a lamination interface (hetero interface) due to the large polarization effects (spontaneous polarization effect and piezo polarization effect) specific to nitride materials (for example, see Non-Patent Document 1).

In some cases, a single crystal (dissimilar single crystal) having a composition different from that of a group-III nitride, such as sapphire or SiC, is used as a base substrate for a HEMT-device substrate. In this case, a buffer layer such as a strained-superlattice layer or a low-temperature growth buffer layer is typically formed as an initially-grown layer on the base substrate. This means that the configuration including a barrier layer, a channel layer, and a buffer layer epitaxially formed on a base substrate is the most basic configuration of a HEMT-device substrate including a base substrate made of a dissimilar single crystal. Besides, a spacer layer having a thickness of about 1 nm may be provided between the barrier layer and the channel layer to facilitate the spatial confinement of a two-dimensional electron gas. The spacer layer is made of, for example, AlN. Moreover, a cap layer formed of, for example, an n-type GaN layer or a superlattice layer, may be formed on the barrier layer to control the energy level on the most superficial surface of the HEMT-device substrate and to improve the contact characteristics with an electrode.

For a nitride HEMT device having the most typical configuration including a channel layer made of GaN and a barrier layer made of AlGaN, it is known that the concentration of a two-dimensional electron gas existing in a HEMT-device substrate increases with an increase in the AlN mole fraction of AlGaN that forms a barrier layer (for example, see Non-Patent Document 2). It is conceivable that greatly increasing the two-dimensional electron gas concentration will greatly improve the controllable current density of the HEMT device, that is, handleable power density. At the same time, it is known that increases in the AlN mole fraction and thickness of the barrier layer lead to the deterioration in reliability of the HEMT device (for example, see Non-Patent Document 6).

A HEMT device with little strain, which is less dependent on the piezo polarization effect and can generate a high-concentration two-dimensional electron gas by substantially only spontaneous polarization, is attracting attention, such as a HEMT device including a channel layer made of GaN and a barrier layer made of InAlN (for example, Non-Patent Documents 3 and 4).

A power device having a breakdown voltage of 800 V or more is well known, which is formed of a HEMT device including a channel layer made of GaN and a barrier layer made of AlGaN (for example, see Non-Patent Document 5).

Meanwhile, in producing the above-mentioned nitride device, the use of single crystal silicon as a base substrate has been researched and developed for, for example, cost reduction of an epitaxial substrate and integration with a silicon-based circuit device (for example, see Patent Documents 1 to 7). In the case where a conductive material such as silicon is selected for the base substrate of the HEMT-device epitaxial substrate, the field plate effect is provided from the back surface of a base substrate, so that a HEMT device suitable for a high breakdown voltage and high-speed switching can be designed.

Prior Art Documents

Patent Documents

Patent Document 1: International Publication No. 2011/016304
Patent Document 2: International Publication No. 2011/102045
Patent Document 3: International Publication No. 2011/122322
Patent Document 4: International Publication No. 2011/135963
Patent Document 5: International Publication No. 2011/136051
Patent Document 6: International Publication No. 2011/136052
Patent Document 7: International Publication No. 2011/166496

Non-Patent Documents

Non-Patent Document 1: "Highly Reliable 250W High Electron Mobility Transistor Power Amplifier", Toshihide KIKKAWA, Jpn. J. Appl. Phys. 44 (2005), 4896
Non-Patent Document 2: "Gallium Nitride Based High Power Heterojunction Field Effect Transistors: Process Development and Present Status at USCB", Stacia Keller, Yi-Feng Wu, Giacinta Parish, Naiqian Ziang, Jane J. Xu, Bernd P. Keller, Steven P. DenBaars, and Umesh K. Mishra, IEEE Trans. Electron Devices 48 (2001), 552
Non-Patent Document 3: "Can InAlN/GaN be an alternative to high power/high temperature AlGaN/GaN devices?", Medjdoub, J.-F. Carlin, M. Gonschorek, E. Feltin, M.A. Py, D. Ducatteau, C. Gaquiere, N. Grandjean, and E. Kohn, IEEE IEDM Tech. Digest in IEEE IEDM 2006, 673
Non-Patent Document 4: "Off-state breakdown in InAlN/AlN/GaN high electron mobility transistors", J. Kuzmik, G. Pozzovivo, J.-F. Carlin, M. Gonschorek, E. Feltin, N. Grandjean, G. Strasser, D. Pogany, and E. Gornik, Phys. Status Solidi C6, No. S2, S925(2009)
Non-Patent Document 5: "Evaluation of AlGaN/GaN Heterostructure Field-Effect Transistors on Si Substrate in Power Factor Currection Circuit", Shinichi IWAKAMI, Osamu MACHIDA, Yoshimichi IZAWA, Ryohei BABA, Masataka YANAGIHARA, Toshihiro EHARA, Nobuo KANEKO, Hirokazu GOTO, and Akio IWABUCHI, Jpn. J. Appl. Phys. 46 (2007), L721
Non-Patent Document 6: "Time-Dependent Degradation of AlGaN/GaN Heterostructures Grown on Silicon Carbide", D.W. GOTTHOLD, S.P. GUO, R. BIRKHAHN, B. ALBERT, D. FLORESCU, and B. PERES, J. Electron. Mater. 33, (2004)408

Summary of Invention

Problems to be Solved by the Invention

In the formation of a HEMT device, a Schottky junction is typically formed on a gate electrode. Unfortunately, the HEMT device including a channel layer made of GaN and a barrier layer made of InAlN has low breakdown voltage when reverse voltage is applied to the Schottky junction (see Non-Patent Documents 3 and 4). The use of a HEMT device on medium to high breakdown voltage requires a breakdown voltage of 600 V or more. However, there is no report that a breakdown voltage of 600 V or more has been obtained.

For practical use of a HEMT device, the concentration of a two-dimensional electron gas (2DEG) needs to be $1.0 \times 10^{13} \mathrm{cm}^{-2}$ or more in a heterojunction. The inventors of the present invention have made intensive studies to find out that the HEMT device including a channel layer made of GaN and a barrier layer made of InAlN has a breakdown voltage of less than 600 V in the case where the concentration is $2.0 \times 10^{13} \mathrm{cm}^{-2}$ or more.

The present invention has been made in view of the above-mentioned problems and has an object to provide a lattice-matched HEMT device including a channel layer made of GaN and a barrier layer made of a group-III nitride containing In and Al, which is a HEMT device having high reverse breakdown voltage while keeping a two-dimensional electron gas concentration in a practical range.

Means to Solve the Problems

To solve the above-mentioned problems, a first aspect of the present invention relates to a semiconductor device including a base substrate, a channel layer formed on the base substrate and made of GaN, a barrier layer formed on the channel layer and made of a group-III nitride having a composition of $\mathrm{In}_x\mathrm{Al}_y\mathrm{Ga}_z\mathrm{N}$ (x+y+z=1, 0≤z≤0.3), and a source electrode, a drain electrode, and a gate electrode formed on the barrier layer. If d represents a thickness of the barrier layer, x, z, and d satisfy the ranges below.

[Math 1]

$$d \leq 30$$

[Math 2]

$$d < 0.06\exp(48(x + 0.3z - 0.1)) + 4.8$$

$$d \geq 0.3\exp(22(x + 0.3z - 0.1)) + 3$$

[Math 4]

$$-\frac{z - 0.875}{5.54} < x < -\frac{z - 1.123}{5.56}$$

In a second aspect of the present invention, the semiconductor device according to the first aspect further includes a spacer layer made of a group-III nitride containing at least Al between the channel layer and the barrier layer.

In a third aspect of the present invention, in the semiconductor device according to the first or second aspect, the substrate includes a Si single crystal base material, a first base layer formed on the Si single crystal base material and made of AlN, a second base layer formed on the first base layer and made of $Al_pGa_{1-p}N$ ($0 \leq p < 1$), and a buffer layer formed immediately above the second base layer. The first base layer is a layer with many crystal defects formed of at least one kind from a columnar or granular crystal or domain. An interface between the first base layer and the second base layer is a three-dimensional concavo-convex surface. The channel layer is formed on the buffer layer.

In a fourth aspect of the present invention, in the semiconductor device according to the third aspect, the buffer layer includes at least one composition modulation layer formed of a first composition layer and a second composition layer, the first composition layer being made of AlN, the second composition layer being made of a group-III nitride having a composition of $Al_{xi}Ga_{1-xi}N$ ($0 \leq xi < 1$).

In a fifth aspect of the present invention, in the semiconductor device according to the first or second aspect, the substrate is an AlN template substrate including an AlN buffer layer formed on a predetermined single crystal base material.

A sixth aspect of the present invention relates to a method for manufacturing a semiconductor device, which includes a substrate preparing step of preparing a base substrate, a channel layer forming step of forming a channel layer made of GaN on the base substrate, a barrier layer forming step of forming a barrier layer made of a group-III nitride having a composition of $In_xAl_yGa_zN$ ($x+y+z=1$, $0 \leq z \leq 0.3$) on said channel layer, and an electrode forming step of forming a source electrode, a drain electrode, and a gate electrode on the barrier layer. In the barrier layer forming step, if d represents a thickness of the barrier layer, the barrier layer is formed such that x, z, and d satisfy the ranges below.

[Math 5]

$$d \leq 30$$

[Math 6]

$$d < 0.06\exp(48(x + 0.3z - 0.1)) + 4.8$$

[Math 7]

$$d \geq 0.3\exp(22(x + 0.3z - 0.1)) + 3$$

[Math 8]

$$-\frac{z-0.875}{5.54} < x < -\frac{z-1.123}{5.56}$$

In a seventh aspect of the present invention, the method for manufacturing a semiconductor device according to the sixth aspect further includes a spacer layer forming step of forming a spacer layer made of a group-III nitride containing at least Al on the channel layer, wherein the barrier layer is formed on the spacer layer.

In an eighth aspect of the present invention, in the method for manufacturing a semiconductor device according to the sixth or seventh aspect, the substrate preparing step includes a first base layer forming step of forming a first base layer made of AlN on a Si single crystal base material, a second base layer forming step of forming a second base layer made of $Al_pGa_{1-p}N(0 \leq p < 1)$ on the first base layer, and a buffer forming step of forming a buffer layer immediately above the second base layer. In the first base layer forming step, the first base layer is formed as a layer with many crystal defects formed of at least one kind from a columnar or granular crystal or domain, a surface thereof being a three-dimensional concavo-convex surface. In the channel layer forming step, the channel layer is formed on the buffer layer.

In a ninth aspect of the present invention, in the buffer layer forming step in the method for manufacturing a semiconductor device according to the eight aspect, a composition modulation layer forming step of alternately laminating a first composition layer made of AlN and a second composition layer made of a group-III nitride having a composition of $Al_{xi}Ga_{1-xi}N$ ($0 \leq xi < 1$) is performed at least once to form one composition modulation layer, to thereby provide at least the one composition modulation layer on the buffer layer.

In a tenth aspect of the present invention, in the method for manufacturing a semiconductor device according to the sixth or seventh aspect, the substrate preparing step includes a template substrate forming step of forming an AlN buffer layer on a predetermined single crystal base material to form an AlN template substrate.

Effects of the Invention

The first to tenth aspects of the present invention achieve a HEMT device that has a lattice-matched composition including a channel layer made of GaN and a barrier layer made of a group-III nitride containing In and Al, and has a high breakdown voltage of 600 V or more while keeping a two-dimensional electron gas concentration of $1.0 \times 10^{13} \mathrm{cm}^{-2}$ or more.

Brief Description of Drawings

Fig. 1 is a schematic cross-sectional view showing an outline configuration of a HEMT device 20.
Fig. 2 schematically shows the ranges represented by (Expression 1) to (Expression 4).
Fig. 3 is a schematic cross-sectional view of a Si-based substrate 10.
Fig. 4 is another schematic cross-sectional view of the Si-based substrate 10.
Fig. 5 is a graph showing a 2DEG concentration and a breakdown voltage of a HEMT device 20 of Example 1, which are plotted against the thickness of a barrier layer 13.
Fig. 6 is a graph showing a 2DEG concentration and a breakdown voltage of a HEMT device 20 of Example 2, which are plotted against the thickness of a barrier layer 13.
Fig. 7 is a mapping diagram showing electrical characteristics of a HEMT device 20 in the case where a Ga mole fraction z of a barrier layer 13 is zero in Example 3.
Fig. 8 is a mapping diagram showing electrical characteristics of the HEMT device 20 in the case where the Ga mole fraction z of the barrier layer 13 is 0.1 in Example 3.
Fig. 9 is a mapping diagram showing electrical characteristics of the HEMT device 20 in the case where the Ga mole fraction z of the barrier layer 13 is 0.2 in Example 3.
Fig. 10 is a mapping diagram showing electrical characteristics of the HEMT device 20 in the case where the Ga mole fraction z of the barrier layer 13 is 0.3 in Example 3.

Description of Embodiment

<Outline Configuration of HEMT device>

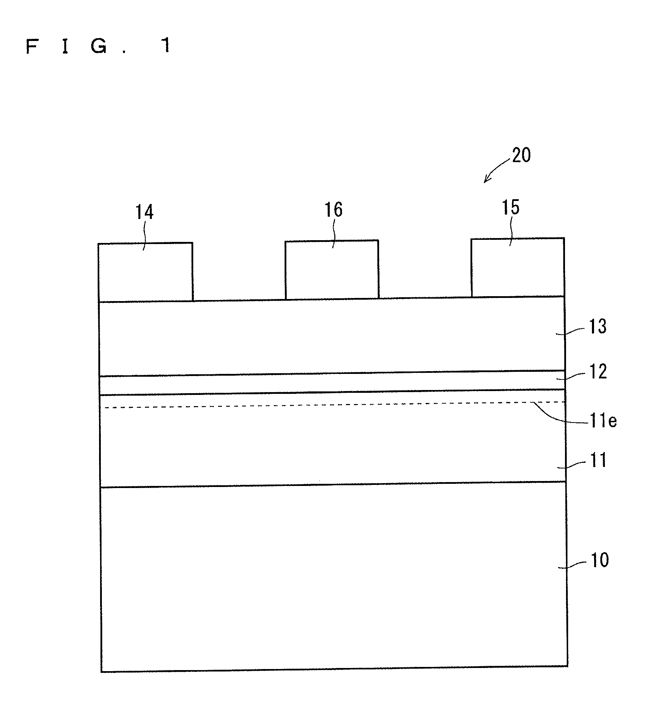

Fig. 1 is a schematic cross-sectional view showing an outline configuration of a HEMT device 20 according to an embodiment of the present invention. The HEMT device 20 includes a substrate (base substrate) 10, a channel layer 11, a spacer layer 12, a barrier layer 13, a source electrode 14, a drain electrode 15, and a gate electrode 16.

Any substrate is generally applicable as the substrate 10 as long as the channel layer 11, spacer layer 12, and barrier layer 13 having good crystallinity can be formed thereon. For example, the substrate 10 may be a single-crystal substrate such as 6H-SiC, 4H-SiC, 3C-SiC, sapphire, Si, GaAs, spinel, MgO, ZnO, or ferrite or may be the above-mentioned single-crystal substrate including an appropriate group-III nitride semiconductor layer or the like formed thereon.

Although the thickness of the substrate 10 is not particularly limited, for convenience of handling, the substrate 10 having a thickness of several hundred $\mu$m to several mm is preferably used.

To be specific, preferable examples of the substrate 10 include a so-called AlN template substrate including a buffer layer made of AlN on a 6H-SiC single crystal base material, a 4H-SiC single crystal base material, or a sapphire single crystal base material to have a thickness of about 10 nm to 10 $\mu$m.

Alternatively, as disclosed in, for example, Patent Documents 1 to 7, the substrate 10 is preferably obtained by providing a base layer on a Si single crystal base material and then forming a buffer layer thereon by various laminating techniques. The base layer is formed by laminating a first base layer, which is a layer with many crystal defects made of a large number of columnar crystals of AlN to have grain boundaries, and a second base layer made of a group-III nitride having a composition of $Al_pGa_{1-p}N$ ($0 \leq p < 1$). In such a case, a crack-free substrate 10 whose warpage is suppressed can be obtained with the use of a relatively inexpensive Si single-crystal substrate. A specific configuration example of the substrate 10 in that case is described below.

From the viewpoint of securing high reverse breakdown voltage in the HEMT device 20, the substrate 10 is desirably an insulating substrate having high breakdown voltage. This is because even in the case where a high gate breakdown voltage of, for example, 600 V or more is obtained, a breakdown may occur between the drain electrode 15 and the substrate 10, making it difficult for the HEMT device 20 to obtain a breakdown voltage of 600 V or more as its entirety. In the case where a conductive single-crystal substrate is used, the buffer layer and the like provided on the single-crystal substrate, for example, the AlN buffer layer on the 6H-SiC single-crystal substrate, the 4H-SiC single-crystal substrate, or the sapphire single-crystal substrate, and the first base layer, the second base layer, and the buffer layer on the Si single-crystal substrate, may be formed to have a breakdown voltage of 600 V or more.

The channel layer 11 is a layer formed on the substrate 10 by epitaxially growing GaN to have a thickness of about 100 nm to 3 $\mu$m.

The barrier layer 13 is a layer formed by epitaxially growing a group-III nitride having a composition of $In_xAl_yGa_zN$ ($x+y+z=1$) where $0 \leq z \leq 0.3$. The barrier layer 13 is formed to have a thickness that satisfies at least the range of 4 nm or more and 30 nm or less. The thickness of the barrier layer 13 of less than 4 nm is not preferable because the two-dimensional electron gas concentration enough to cause the HEMT device to function is not provided. Meanwhile, the thickness of the barrier layer 13 exceeding 30 nm makes the epitaxial growth per se difficult.

The thickness and composition of the barrier layer 13 are closely related to increasing the breakdown voltage of the HEMT 20 according to this embodiment. More preferable ranges of the composition and thickness of the barrier layer 13 are described below.

The channel layer 11 and the barrier layer 13 are formed so as to satisfy such a compositional range that the band gap of a group-III nitride constituting the latter is larger than the band gap of GaN constituting the former.

Further, the spacer layer 12 is provided between the channel layer 11 and the barrier layer 13. The spacer layer 12 is a layer epitaxially formed of a group-III nitride containing at least Al to have a thickness in the range of 0.5 nm to 1.5 nm. The spacer layer 12 is preferably made of AlN.

The channel layer 11, the spacer layer 12, and the barrier layer 13 may be collectively referred to as a functional layer below. Also, the layer epitaxially formed in the production of the substrate 10 in addition to the functional layer may be collectively referred to as an epitaxial film. Moreover, for example, the abundance ratio of Al in a group-III element may be referred to as an Al mole fraction for the sake of convenience. This holds true for In and Ga.

The epitaxial film is formed of a wurtzite-type group-III nitride such that a (0001) crystal plane is substantially parallel to the substrate surface of a base material 1. As an example, the layers of the epitaxial film are preferably formed by a metal organic chemical vapor deposition method (MOCVD method).

In the substrate 10 having the layers configured as described above, a two-dimensional electron gas region 11e, having a high concentration of two-dimensional electron gas, is formed at an interface between the channel layer 11 and the spacer layer 12 (more specifically, in the vicinity of the interface in the channel layer 11).

The spacer layer 12 and the barrier layer 13 are each preferably formed to satisfy such a compositional range that the band gap of a group-III nitride constituting the former is equal to or larger than the band gap of a group-III nitride constituting the latter. In this case, an alloy scattering effect is suppressed, improving the concentration and mobility of the two-dimensional electron gas. More preferably, the spacer layer 12 is made of AlN. In this case, the spacer layer 12 is a binary compound of Al and N, further suppressing an alloy scattering effect than in the case of a ternary compound containing Ga, which further improves the concentration and mobility of the two-dimensional electron gas. Note that the discussion on the composition range does not exclude the case in which the spacer layer 12 contains impurities.

The HEMT device 20 is not necessarily required to include the spacer layer 12 but may include the barrier layer 13 directly formed on the channel layer 11. In this case, the two-dimensional electron gas region 11e is formed at the interface between the channel layer 11 and the barrier layer 13.

The source electrode 14 and the drain electrode 15 are multilayer metal electrodes including metal layers, each of which has a thickness of about a dozen or so nm to a hundred and several tens nm, and are in ohmic contact with the barrier layer 13. The metals used for the source electrode 14 and the drain electrode 15 may be formed of metal materials that can be in good ohmic contact with the substrate 10 (with the barrier layer 13). It is preferable to form a multilayer metal electrode made of Ti/Al/Ni/Au as the source electrode 14 and the drain electrode 15, which is not limited thereto. For example, a multilayer metal electrode made of Ti/Al/Pt/Au, Ti/Al, or the like may be formed. The source electrode 14 and the drain electrode 15 may be formed by a photolithography process and a vapor deposition method.

The gate electrode 16 is a single-layer or multilayer metal electrode including one or a plurality of metal layers, each of which has a thickness of about a dozen or so nm to a hundred and several tens nm, and is in Schottky contact with the barrier layer 13. The gate electrode 16 is preferably formed of metals having a high work function, such as Pd, Pt, Ni, and Au as formation materials. Or, the gate electrode 16 may be formed as a multilayer metal film of the metals described above or a multilayer metal film of each of the metals and Al. The gate electrode 16 can be formed by a photolithography process and a vapor deposition method.

The interval between the gate electrode 16 and the drain electrode 15 is preferably 8 μm or more. Such an interval can obtain a lateral breakdown voltage of 600 V or more in the HEMT device 20.

Between the barrier layer 13 and the gate electrode 16 may be formed a cap layer made of GaN and AlN formed through epitaxial growth or an insulating layer made of SiN, $SiO_2$, and $Al_2O_3$ deposited separately after the epitaxial growth. Although the junction between the barrier layer 13 and the gate electrode 16 is not generally referred to as a Schottky junction in this case, the junction can be substantially regarded as a Schottky junction if the cap layer and the insulating layer per se do not have a breakdown voltage of 600 V or more. In this embodiment, thus, the junction between the barrier layer 13 and the gate electrode 16 is regarded as a Schottky junction, which includes the case in which a cap layer and an insulating layer are provided therebetween.

<Increasing Breakdown Voltage of HEMT Device>

Increasing the breakdown voltage of the HEMT device, achieved in this embodiment, is described next.

In this embodiment, the values of the thickness d and composition x of the barrier layer 13 are set to satisfy the ranges expressed by (Expression 1) to (Expression 4) where $0 \leq z \leq 0.3$.

[Math 9]

$$d \leq 30 \cdots (Expression\ 1)$$

[Math 10]

$$d < 0.06 \exp(48(x + 0.3z - 0.1)) + 4.8 \cdots (Expression\ 2)$$

[Math 11]

$$d \geq 0.3 \exp(22(x + 0.3z - 0.1)) + 3 \cdots (Expression\ 3)$$

[Math 12]

$$-\frac{z-0.875}{5.54} < \mathrm{x} < -\frac{z-1.123}{5.56} \cdots (Expression\ 4)$$

If (Expression 1) to (Expression 4) are all satisfied, the HEMT device 20 is preferably achieved, which has a breakdown voltage of 600 V or more during application of a reverse voltage to a Schottky junction and has a 2DEG concentration of not $1.0 \times 10^{13} cm^{-2}$ or more.

Herein, (Expression 1) is a requisite for preferably epitaxially forming the barrier layer 13 as described above. (Expression 3) is a requisite for achieving a 2DEG concentration of $1.0 \times 10^{13} cm^{-2}$ or more. The HEMT device 20 that satisfies (Expression 2) has a 2DEG concentration of $2.0 \times 10^{13}\ cm^{-2}$ or less.

(Expression 4) is a requisite for keeping crystal strains (lattice strains) that act on the barrier layer 13 within $\pm 0.3\%$. In other words, (Expression 4) is a requisite for producing the HEMT device 20 as a lattice-matched device. If the lattice strains are out of $\pm 0.3\%$, the lattice strains greatly affect the reliability of device characteristics, and thus, the HEMT device 20 cannot be regarded as a lattice-matched device.

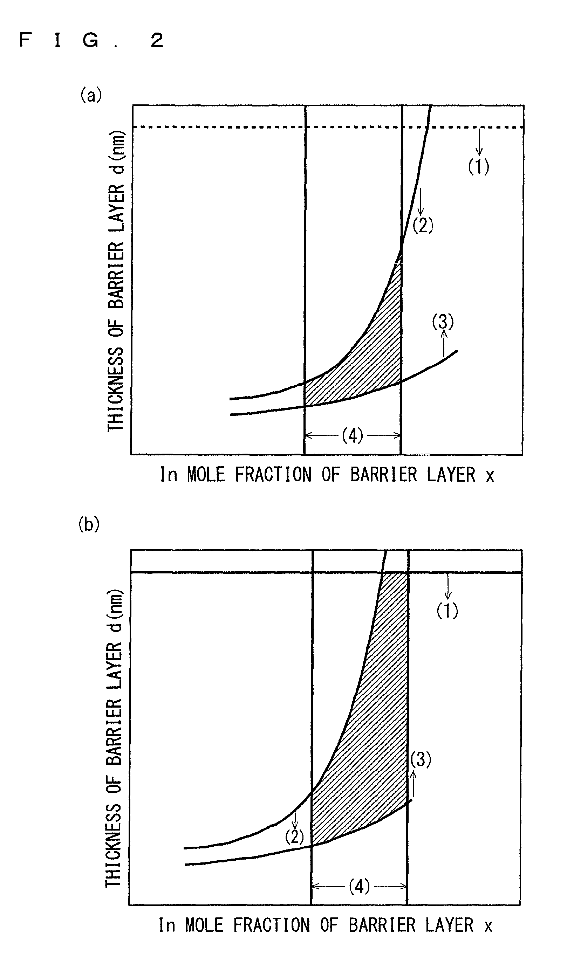

Fig. 2 schematically shows the ranges expressed by (Expression 1) to (Expression 4). Fig. 2(a) shows the case of $z \leq 0.2$ and Fig. 2(b) shows the case of $0.2 < z \leq 0.3$. In the former case, the upper limit of (Expression 2) is always smaller than the upper limit of (Expression 1) in the range of (Expression 4), and thus, it suffices that the ranges expressed by (Expression 2) to (Expression 4) are substantially satisfied. Here, $z \leq 0.3$ because it is difficult to obtain good crystal growth in the barrier layer 13 enough to obtain a 2DEG concentration of $1.0 \times 10^{13} cm^{-2}$ or more within the range of crystal strains of $\pm 0.3\%$.

The lower limit of (Expression 3) is greater than 4 nm in the range in which (Expression 4) is satisfied.

If (Expression 1) to (Expression 4) are satisfied, a HEMT device 20, which is lattice-matched and has a high breakdown voltage of 600 V or more, can be obtained with the various compositions of the substrate 10 and the electrodes.

For example, in the case where the barrier layer 13 is formed within the range of 5 nm or more and 7.5 nm or less that satisfies Expressions 1, 2, and 3 with such a composition of $In_{0.18}Al_{0.82}N$ satisfying Expression 4, a high breakdown voltage of 800 V or more is obtained irrespective of the types of the substrate 10 and the gate electrode 16. The 2DEG concentration at this time is $1.0 \times 10^{13} cm^{-2}$ or more and $2.0 \times 10^{13} cm^{-2}$ or less.

This embodiment, which satisfies (Expression 1) to (Expression 4), can achieve a HEMT device that has a composition of a lattice-matched device including a channel layer made of GaN and a barrier layer made of a group-III nitride containing In and Al and has a high breakdown voltage of 600 V or more while keeping a two-dimensional electron gas concentration of $1.0 \times 10^{13} cm^{-2}$ or more.

<Exemplary Configuration of Substrate Including Si Single-Crystal Base Material>

In the case where the substrate including a Si single crystal as a base material and also including a base layer and a buffer layer formed thereon is used as the substrate 10, substrates 10 having various configurations can be produced and used by forming buffer layers in various manners.

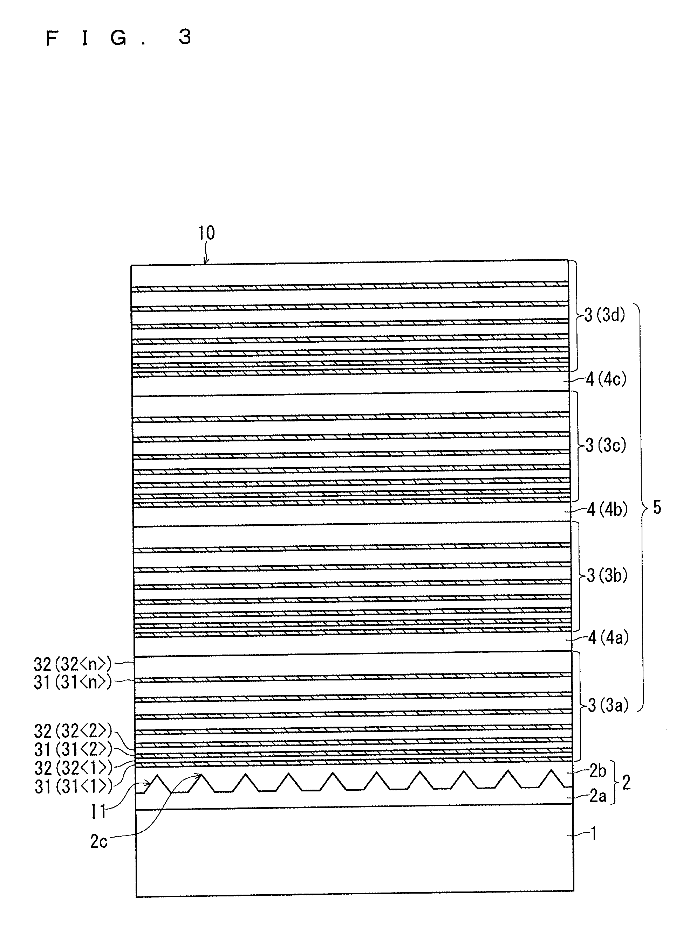

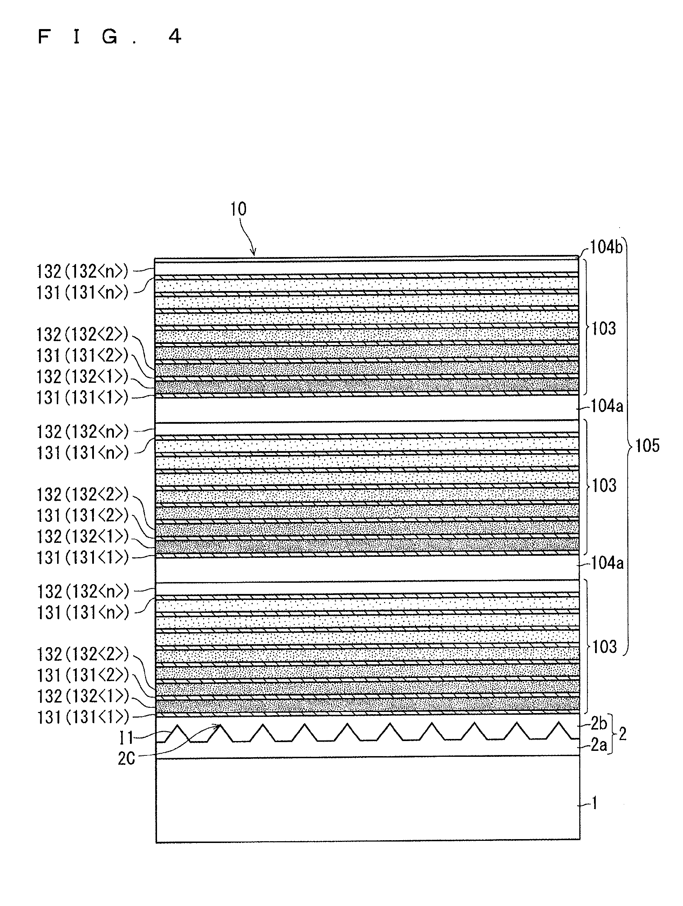

Figs. 3 and 4 are cross-sectional views schematically showing two types of substrates that are common to each other in that the base material 1, and a base layer 2 including a first base layer 2a and a second base layer 2b are provided but are different from each other in the configuration of a buffer layer. The substrates 10 illustrated in Figs. 3 and 4 are also referred to as Si-based substrates 10 below.

The base material 1 is a (111) plane Si single crystal wafer having a p-type conductivity. The thickness of the base material 1 is not particularly limited, but for the sake of handling, it is preferable to use the base material 1 having a thickness of several hundred $\mu$m to several mm.

As described above, the first base layer 2a is a layer made of AlN with many defects that is formed of a large number of columnar or granular crystals or a large number of columnar crystals being at least one type of domains, to thereby include grain boundaries therein. The interval between the grain boundaries in the first base layer 2a is about several tens nm at most.

The first base layer 2a is formed such that the half width of a (0002) plane X-ray rocking curve can be 0.5 degrees or more and 1.1 degrees or less and such that the half width of a (10-10) plane X-ray rocking curve can be 0.8 degrees or more and 1.1 degrees or less. The half width of the (0002) plane X-ray rocking curve serves as an index of the magnitude of mosaicity of a c-axis tilt component or the frequency of screw dislocations. The half width of the (10-10) plane X-ray rocking curve serves as an index of the magnitude of mosaicity of a crystal rotation component whose rotation axis is the c-axis or the frequency of edge dislocations.

The second base layer 2b, which is a layer formed of a group-III nitride having a composition of $Al_pGa_{1-p}N$ ($0 \leq p < 1$), is formed to have a surface roughness of 10 nm or less. In this embodiment, the surface roughness is expressed as an average roughness ra for a region of $5\ \mu m \times 5\ \mu m$ which has been measured with an atomic force microscope (AFM).

In the Si-based substrate 10, the first base layer 2a being a layer with many defects is located between the base material 1 and the second base layer 2b, so that a lattice misfit between the base material 1 and the second base layer 2b is relieved, suppressing accumulation of strain energy resulting from the lattice misfit.

The interface I1 between the first base layer 2a and the second base layer 2b is a three-dimensional concavo-convex surface that reflects the outer shapes of the columnar crystals and the like constituting the first base layer 2a. Thus, the dislocations, which originate from the grain boundaries of the columnar crystals and the like of the first base layer 2a and propagate in the second base layer 2b, are bent at the interface I1 and coalesce and disappear within the second base layer 2b. This means that only part of the dislocations penetrate through the second base layer 2b to reach the surface thereof. In other words, the surface of the second base layer 2b (namely, the surface of the base layer 2) is flat and has low dislocations.

Preferably, the first base layer 2a is formed such that the density of the projections 2c can be $5\times10^9/cm^2$ or more and $5\times10^{10}/cm^2$ or less and the average interval of the projections 2c can be 45 nm or more and 140 nm or less. When these ranges are satisfied, the function layer that has a particularly excellent crystal quality can be formed. In this embodiment, the projection 2c of the first base layer 2a denotes a position substantially at the apex of an upward projection of the surface (interface I1).

To form the projections 2c that satisfy the above-mentioned density and average interval on the surface of the first base layer 2a, it is preferable to form the first base layer 2a with an average film thickness of 40 nm or more and 200 nm or less. In the case where the average film thickness is less than 40 nm, it is difficult to achieve a state where the substrate surface is thoroughly covered with AlN while forming the projections 2c as described above. Meanwhile, when the average film thickness exceeds 200 nm, flattening of an AlN surface starts to progress, making it difficult to form the projections 2c as described above.

It is preferable that the second base layer 2b have an average thickness of 40 nm or more. This is because, the average thickness of less than 40 nm causes such problems that irregularities caused by the first base layer 2a cannot be sufficiently flattened and that the dislocations that have propagated in the second base layer 2b do not sufficiently coalese and disappear. In the case where the second base layer 2b is formed to have an average thickness of 40 nm or more, the dislocation density can be reduced effectively and the surface can be flattened effectively. Therefore, in a technical sense, an upper limit of the thickness of the second base layer 2b is not particularly limited, but from the viewpoint of productivity, it is preferable that the thickness be about several $\mu$m or less.

The buffer layer is preferably configured to include a superlattice structural layer or a composition modulation layer formed of two types of layers, which have different compositions, alternately laminated. The buffer layer may be configured by laminating a plurality of such composition modulation layers, with intermediate layers each provided between ones of the layers.

In such a case, one type of the layers may have a constant thickness and the other type of the layers may have thicknesses that vary gradually. Fig. 3 illustrates the case in which three intermediate layers 4 (4a, 4b, 4c) are each provided between ones of four composition modulation layers 3 (3a, 3b, 3c, 3d) to form a buffer layer 5. In the four composition modulation layers 3, the first composition layers 31 made of AlN have a constant thickness, whereas the second composition layers 32 made of a group-III nitride having a composition of $Al_{x1}Ga_{1-x1}N$ ($0\leq x1\leq0.25$) have gradually increasing thicknesses as they are located farther from the base material 1. The number of composition modulation layers 3 and the number of intermediate layers 4 are not limited thereto.

Alternatively, the buffer layer may be configured by providing composition modulation layers such that one type of layers have a constant composition and the other type of layers have gradually varying compositions (are compositionally graded), while alternately laminating the layers having different compositions as described above. Fig. 4 illustrates the case in which intermediate layers 104a are each provided between ones of a plurality of composition modulation layers 103 and a termination layer 104b is provided in an uppermost portion to form a buffer layer 105. In the plurality of composition modulation layers 103, first composition layers 131 are made of AlN, whereas second composition layers 132 are made of a group-III nitride having a composition of $Al_{x2}Ga_{1-x2}N$ ($0\leq x2<1$) having gradually decreasing thicknesses as they are located farther from the base material 1. Although Fig. 4 illustrates the case in which two intermediate layers 104a are each provided between ones of three composition modulation layers 103, the number of composition modulation layers 103 and the number of intermediate layers 104a are not limited thereto. The termination layer 104b is formed to have the same composition (than is, AlN) and thickness as those of the first composition layer 131, and is substantially the layer regarded as part of the uppermost composition modulation layer 103.

In the following description, the i-th first composition layer 31 from the base material 1 is denoted as "31<i>", and the i-th second composition layer 32 from the base material 1 is denoted as "32<i>". The same holds true for the first composition layers 131 and the second composition layers 132.

The first composition layers 31 and the first composition layers 131 are formed to have substantially the same thickness of about 3 to 20 nm, typically, 5 to 10 nm.

The second composition layers 32 of Fig. 3 are formed such that

$$t(1) \leq t(2) \leq \cdots \leq t(n-1) \leq t(n) \cdots (Expression\ 5)$$

$$t(1) < t(n) \qquad\qquad \cdots (Expression\ 6)$$

where n (n is a natural number equal to or larger than two) represents the number of first composition layers 31 and the number of second composition layers 32, more specifically, t(i) represents the thickness of the i-th second composition layer 32 <i> from the base material 1. It can be regarded in outline that the second composition layers 32 are formed to have a larger thickness as they are located farther from the base material 1.

The second composition layers 132 of Fig. 4 are formed such that

$$x(1) \geq x(2) \geq \cdots \geq x(n-1) \geq x(n) \cdots (Expression\ 7)$$

$$x(1) > x(n) \qquad\qquad \cdots (Expression\ 8)$$

where n (n is a natural number equal to or larger than two) represents the number of first composition layers 131 and the number of second composition layers 132, more specifically, x(i) represents the Al mole fraction x of the i-th second composition layer 132 <i> from the base material 1. It can be regarded in outline that the second composition layers 132 are formed to have a smaller Al mole fraction as they are located farther from the base material 1. The above-mentioned manner in which the second composition layers 132 are formed is also referred to as a manner of compositionally grading the second composition layers 132. The second composition layers 132 are preferably formed to have a thickness of about 10 to 25 nm, typically 15 to 35 nm. The value of n is about 10 to 40.

The first composition layer 31 or 131 and the second composition layer 32 or 132 are formed so as to satisfy such a relation that the group-III nitride constituting the latter has a larger in-plane lattice constant (lattice length) in strain-free state (bulk state) than the group-III nitride constituting the former.

Additionally, the second composition layer 32 or 132 is formed so as to be coherent to the first composition layer 31 or 131. Herein, the state in which the second composition layer 32 or 132 is coherent to the first composition layer 31 or 131 means that the second composition layer 32 or 132 keeps holding strain energy (keeps having compressive strain), due to the constitution that the second composition layer 32 or 132 has been formed on the first composition layer 31 of 131 to have a thickness smaller than a critical film thickness at which strain energy is completely released enough. In the composition modulation layer 3 or 103, as long as the uppermost surface of the second composition layer 32 or 132 (surface being in contact with the first composition layer 31 or 131 located immediately thereabove) has an in-plane lattice length smaller than a lattice length in a strain-free state, the second composition layer 32 or 132 can be regarded as being coherent to the first composition layer 31 or 131.

The composition modulation layers 3 or 103 are accordingly strain-introduced layers formed to have a larger compressive strain as they are located farther from the base material 1.

The intermediate layer 4 or 104a is formed of AlN to have a thickness of 15 nm or more and 150 nm or less. In the intermediate layer 4 or the intermediate layer 104a, a misfit dislocations resulting from a difference in the lattice constant from the second composition layer 32 or 132 exist in the vicinity of the interface with the second composition layer 32 or 132, but at least in the vicinity of the surface of the intermediate layer 4 or the intermediate layer 104a, lattice relaxation occurs and a substantially strain-free state can be obtained, in which substantially no tensile stress acts. Here, being substantially strain-free means that at least the portion other than the vicinity of the interface with the second composition layer 32 or 132 has a lattice constant substantially the same as the lattice constant in the bulk state.

In the buffer layer 5 or 105, another composition modulation layer 3 or 103 is formed on the intermediate layer 4 or 104a being substantially strain-free as seen above. The composition modulation layer 3 is accordingly formed to have compressive strains similarly to the composition modulation layer 3 or 103 immediately below the intermediate layer 4 or 104a.

As a result, in the Si-based substrate 10, the whole buffer layer 5 or 105 has large compressive strains. This results in a state in which a tensile stress resulting from a difference in the thermal expansion coefficient between silicon and a group-III nitride is sufficiently cancelled. The Si-based substrate 10 is thus crack-free and has an amount of warpage reduced to 100 $\mu$m or less.

The use of the Si-based substrate 10 allows the HEMT device 20 to be obtained, which has excellent characteristics, with a relatively inexpensive Si single crystal base material. The configurations of the buffer layers shown in Figs. 3 and 4 are merely examples, and similar effects can be achieved as long as the configurations are as disclosed in Patent Documents 1 to 7 are provided.

<Method for Manufacturing HEMT Device>

Next, the method for manufacturing the HEMT device 20 is outlined. The following description is given of an example in which an epitaxial film is formed using the MOCVD method and a large number of HEMT devices 20 are obtained from one mother substrate.

First, the substrate 10 is prepared. The substrate 10 may be prepared by being appropriately selected from the single crystal base materials having various materials described above. Or, the substrate 10 may be prepared as a substrate obtained by forming a buffer layer and the like on the single crystal base material.

For example, in the case where an AlN template substrate, obtained by forming a buffer layer made of AlN on a 6H-SiC single crystal base material, 4H-SiC single crystal base material, or sapphire single crystal base material, is used as the substrate 10, an AlN buffer layer is formed on the thus prepared single crystal base material at a formation temperature of 950 to 1250°C by the MOCVD method, so that the substrate 10 is obtained.

In the case where the Si-based substrate 10 having the configuration as illustrated in Figs. 3 and 4 is obtained with the base material 1 made of Si, the Si-based substrate 10 can be manufactured through the following procedure.

First, a (111) plane Si single crystal wafer is prepared as the base material 1, and then, a natural oxide film is removed by dilute hydrofluoric acid cleaning. After that, SPM cleaning is further performed such that an oxide film having a thickness of about several Å is formed on the wafer surface. This is set in a reactor of an MOCVD apparatus.

Then, the layers are formed under predetermined heating conditions and a predetermined gas atmosphere. First, the first base layer 2a made of AlN can be formed as follows. A substrate temperature is kept at a predetermined first-base-layer formation temperature of 800°C or higher and 1200°C or lower, and the pressure in the reactor is set to 0.1 to 30 kPa. In this state, a trimethylaluminum (TMA) bubbling gas that is an aluminum raw material and a $NH_3$ gas are introduced into the reactor at an appropriate molar flow ratio. Then, a film formation speed is set to 20 nm/min or more and a target film thickness is set to 200 nm or less.

The second base layer 2b is formed as follows. After the formation of the first base layer 2a, the substrate temperature is kept at a predetermined second-base-layer formation temperature of 800°C or higher and 1200°C or lower, and the pressure in the reactor is set to 0.1 to 100 kPa. In this state, a trimethylgallium (TMG) bubbling gas that is a gallium raw material, a TMA bubbling gas, and a $NH_3$ gas are introduced into the reactor at a predetermined flow ratio corresponding to the composition of the second base layer 2b to be produced. Then, $NH_3$ is reacted with TMA and TMG to form the second base layer 2b.

Subsequent to the formation of the second base layer 2b, the layers constituting the buffer layer 5 or 105 are formed as follows. The substrate temperature is kept at a predetermined formation temperature of 800°C or higher and 1200°C or lower suitable for each of the layers, and the pressure in the reactor was set to a predetermined value of 0.1 to 100 kPa suitable for each layer. In this state, a $NH_3$ gas and a group-III nitride material gas (TMA and TMG bubbling gases) are introduced into the reactor at a flow ratio suitable for a composition to be achieved in each of the layers. On that occasion, the flow ratio is changed at a timing suitable for the set film thickness, so that the layers are formed to have desired film thicknesses in a continuous manner. Consequently, the Si-based substrate 10 is obtained.

A function layer is formed on the substrate 10 prepared as described above. In the case where an AlN template substrate, Si-based substrate, or other substrate is used as the substrate 10, the function layer may be formed successively to the production of such a substrate.

The layers constituting the function layer are formed as follows. A substrate temperature is kept at a predetermined formation temperature of 800°C or higher and 1200°C or lower, and the pressure in the reactor is set to 0.1 to 100 kPa. In this state, a $NH_3$ gas and at least one of a trimethylindium (TMI) gas, a TMA bubbling gas, and a TMG bubbling gas are introduced into a rector at a flow ratio suitable for the composition of each layer, to thereby react $NH_3$ with at least one of TMI, TMA, and TMG to form the function layer. The favorable growth rate of the barrier layer 13 is within the range of 0.01 to 0.1 $\mu$m/h. The formation temperatures of the layers may be identical to or different from one another.

The temperature of the substrate (hereinafter, also referred to as an epitaxial substrate) on which the function layer has been formed is lowered to normal temperature in the reactor.

Then, the source electrode 14 and the drain electrode 15 are formed at their target formation positions in the epitaxial substrate taken out from the reactor, using the photolithography process and the vacuum deposition method. After that, to obtain good ohmic properties of the source electrode 14 and the drain electrode 15, the epitaxial substrate is heat-treated for several tens of seconds (for example, for 30 seconds) in a nitrogen gas atmosphere at a predetermined temperature (for example, 800°C) between 650 to 1000°C.

Then, the gate electrode 16 is formed at its target formation position by the vacuum deposition method and the photolithography process. The gate electrode 16 is formed as a Schottky metal pattern.

Lastly, the epitaxial substrate on which the electrodes have been formed is diced into chips, so that the HEMT devices 20 are obtained.

<Modifications>

The substrate 10 including a Si single crystal as the base material 1 may include an interface layer (not shown) between the base material 1 and the first base layer 2a. As one preferable example, the interface layer has a thickness of about several nm and is made of amorphous $SiAl_uO_vN_w$. If the interface layer is provided, a lattice misfit between the base material 1 and the second base layer 2b or the like is relieved more effectively, leading to a further improvement in the crystal quality of each layer formed thereon. The interface layer is formed so as not to have a film thickness not exceeding 5 nm.

The interface layer can be formed by, after the Si single crystal wafer reaches the first-base-layer formation temperature and before the formation of the first base layer 2a, introducing only a TMA bubbling gas into the reactor and exposing the wafer to the TMA bubbling gas atmosphere.

In the formation of the first base layer 2a, at least one of Si atoms and O atoms may diffuse and form a solid solution in the first base layer 2a, or at least one of N atoms and O atoms may diffuse and form a solid solution in the base material 1.

[Examples]

(Example 1)

In this example, an AlN template substrate, including an AlN buffer layer formed on a SiC single crystal base material, was used as the substrate 10 to produce 12 types of HEMT devices 20 different in only the thickness of the barrier layer 13.

To be specific, first, a (0001) plane oriented 6H-SiC single crystal base material having a diameter of three inches and a thickness of 300 $\mu$m was prepared and was placed in an MOCVD reactor. Then, after vacuum gas replacement, the pressure inside the reactor was set to 30 kPa, to thereby form a hydrogen/nitrogen mixed flow state atmosphere. Then, the temperature of the single crystal base material was raised by heating a susceptor.

When the susceptor temperature reached 1050°C, a TMA bubbling gas and a $NH_3$ gas were introduced into the reactor, thereby forming an AlN layer having a thickness of 200 nm as a buffer layer. As a result, the substrate 10 being an AlN template substrate was obtained.

Subsequently, the susceptor temperature was set to a predetermined temperature, and a TMG bubbling gas and a $NH_3$ gas as organic metal material gases were introduced into the reactor at a predetermined flow ratio, thereby forming a GaN layer to have a thickness of 2 $\mu$m as the channel layer 11.

After the channel layer 11 was obtained, the reactor pressure was set to 10 kPa, and then, the TMA bubbling gas and the $NH_3$ gas were introduced into the reactor, thereby forming an AlN layer to have a thickness of 1 nm as the spacer layer 12.

After the spacer layer 12 was formed, the susceptor temperature was set to 745°C, and the reactor pressure was set to 20 kPa. In this state, the TMA bubbling gas, the TMI bubbling gas, and the $NH_3$ gas were introduced into the reactor, thereby forming an $In_{0.18}Al_{0.82}N$ layer as the barrier layer 13. The composition of the barrier layer 13 satisfies the range of (Expression 4). To be more specific, this composition renders a crystal strain of 0%. It can be said that the HEMT device 20 produced in this example is a lattice-matched device.

The thickness of the barrier layer 13 was varied in 12 different types of 4 nm, 5 nm, 6 nm, 7 nm, 7.5 nm, 8 nm, 9 nm, 10 nm, 15 nm, 20 nm, 25 nm, and 30 nm by adjusting the formation time.

After the barrier layers 13 were formed, the susceptor temperature was lowered to around room temperature, and the inside of the reactor was returned to atmospheric pressure. Then, the produced epitaxial substrates were taken out.

Then, part of each of the epitaxial substrates was cut out by dicing and was used as a sample for measuring the Hall effect. The sample was measured for the Hall effect, thereby determining a two-dimensional electron gas concentration of each epitaxial substrate.

Then, an electrode pattern made of Ti/Al/Ni/Au (having film thicknesses of 25/75/15/100nm, respectively) was formed at the positions on the upper surface of each epitaxial substrate, where the source electrode 14 and the drain electrode 15 are to be formed, using the photolithography process and the vacuum deposition method. After that, heating treatment was performed at 800°C under nitrogen for 30 seconds.

Then, the pattern of the gate electrode 16 was formed at the position on the upper surface of each epitaxial substrate, where the gate electrode 16 is to be formed, using the photolithography process and the vacuum deposition method. Formed as the gate electrode 16 were four types in total, three multilayer metal electrodes of Ni/Au (having a film thickness of 6 nm/12 nm), Pd/Au (6 nm/12 nm), and Pt/Au (6 nm/12 nm), and a single layer metal electrode of Au alone (12 nm). The gate electrode 16 was formed to have a gate length of 1 $\mu$m, a gate width of 100 $\mu$m, an interval of 2 $\mu$m between the source electrode 14 and itself, and an interval of 10 $\mu$m between the drain electrode 15 and itself.

Lastly, each epitaxial substrate after the electrode formation was diced into chips, thereby obtaining a large number of HEMT devices 20.

Each of the obtained 12 types of HEMT devices 20 was die-bonded and wire-bonded, and then, drain voltages of 0 V to 800 V were applied thereto with the gate electrode 16 grounded. Then, the breakdown voltage (gate breakdown voltage) was measured.

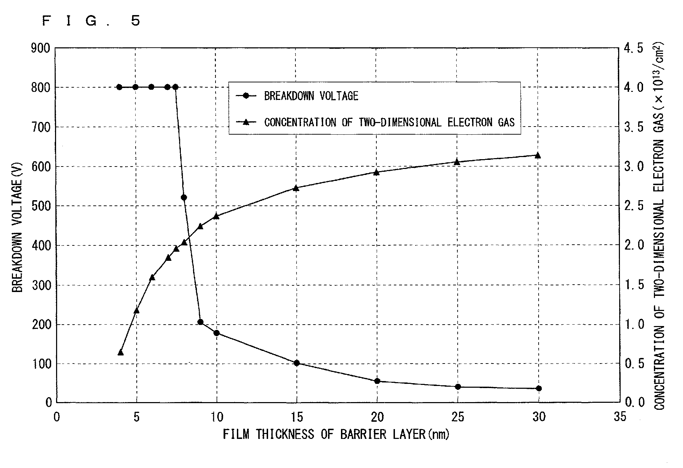

Fig. 5 is a graph showing the 2DEG concentration and breakdown voltage of the HEMT device 20 plotted against the thickness (film thickness) of the barrier layer 13. As for breakdown voltage, there was no difference in the measurement results depending on the type of the gate electrode 16. Thus, Fig. 5 shows the results in the case where the gate electrode 16 was formed of a Pt/Au multilayer metal electrode.

With reference to Fig. 5, the breakdown voltages of the HEMT devices 20 whose barrier layers 13 have a thickness of 7.5 nm or less are all 800 V. This is because a breakdown did not occur even in the case where the drain voltage was set to 800 V. This means that the breakdown voltages of those HEMT devices 20 were 800 V or more.

Meanwhile, the breakdown voltages of the HEMT devices 20 whose barrier layer 13 have a thickness larger than 7.5 nm fell below 600 V, with such a tendency that the breakdown voltage will become smaller as the barrier layer 13 has a larger thickness.

Contrary to the breakdown voltage, the 2DEG concentration of the HEMT device tends to increase as the barrier layer 13 thereof has a larger thickness. The 2DEG concentration was $1.0 \times 10^{13} \text{cm}^{-2}$ or more for the thicknesses of 5 nm or more and $2.0 \times 10^{13} \text{cm}^{-2}$ or more for the thicknesses exceeding 7.5 nm.

The above-mentioned results show that the HEMT device 20 having high breakdown voltage while securing 2DEG concentration can be obtained in the case where the barrier layer 13 was formed of a group-III nitride having a composition of $In_{0.18}Al_{0.82}N$ on the channel layer 11 to have a thickness of 5 nm or more and 7.5 nm or less. The results also confirm that high breakdown voltage cannot be obtained if the 2DEG concentration is $2.0 \times 10^{13} \text{cm}^{-2}$ or more. It has been confirmed that similar effects were achieved also in the case where a 4H-SiC single crystal base material was used in place of the 6H-SiC single crystal base material.

(Example 2)

In this example, 12 types of HEMT devices 20 were produced and evaluated in a procedure similar to that of Example 1 except for that the Si-based substrate having the configuration as shown in Fig. 3 was used as the substrate 10.

First, the Si-based substrate was produced. To be specific, first, a four-inch (111) plane single crystal silicon wafer (hereinafter, "silicon wafer") of p-type conductivity having a thickness of 525 $\mu$m was prepared as the base material 1. Then, the silicon wafer was subjected to dilute hydrofluoric acid cleaning with dilute hydrofluoric acid having a composition of hydrofluoric acid/pure water = 1/10 (volume ratio) and to SPM cleaning with a cleaning liquid having a composition of sulfuric acid/aqueous hydrogen peroxide = 1/1 (volume ratio), so that an oxide film having a thickness of several Å was formed on the wafer surface. Then, the silicon wafer was set in the reactor of an MOCVD apparatus. Then, the mixed atmosphere of hydrogen and nitrogen was set in the reactor, and the pressure in the reactor was set to 15 kPa. Then, heating was performed until the substrate temperature reached 1100°C that is the first-base-layer formation temperature.

When the substrate temperature reached 1100°C, a $NH_3$ gas was introduced into the reactor, and the substrate surface was exposed to a $NH_3$ gas atmosphere for one minute.

After that, a TMA bubbling gas was introduced into the reactor at a predetermined flow ratio to react $NH_3$ with TMA, thereby forming the first base layer 2a having a three-dimensional concavo-convex surface. On that occasion, the growth rate (deposition rate) of the first base layer 2a was set to 20 nm/min, and a target average film thickness of the first base layer 2a was set to 100 nm.

After the first base layer 2a was formed, subsequently, the substrate temperature was set to 1100°C, and the pressure in the reactor was set to 15 kPa. Then, a TMG bulling gas was further introduced into the reactor to react $NH_3$ with TMA and TMG, thereby forming an $Al_{0.1}Ga_{0.9}N$ layer serving as the first base layer 2b to have an average film thickness of about 40 nm.

Subsequent to the formation of the second base layer 2b, the composition modulation layers 3 and the intermediate layers 4 were alternately laminated to form the buffer layer 5. In each composition modulation layer 3, the first composition layer 31 was formed of AlN, and the second composition layer 32 was formed of $Al_{0.2}Ga_{0.8}N$. Five first composition layers 31 and five second composition layers 32 were provided. The thickness of the first composition layer 31 was constant, 5 nm, and the thickness of the second composition layer 32 was doubled per layer from a minimum, 10 nm, to 160 nm. The composition modulation layer 3 was repeated six times, and the intermediate layer 4 made of AlN was formed to have a thickness of 60 nm between ones of the composition modulation layers 3.

In the formation of the buffer layer 5, the substrate temperature was set to 1100°C and the pressure in the reactor was set to 15 kPa. The same material gas as in the formation of the base layer 2 was used.

After the Si-based substrate was obtained through the above-mentioned process, the procedure was performed as in Example 1, so that 12 types of HEMT devices 20 were obtained.

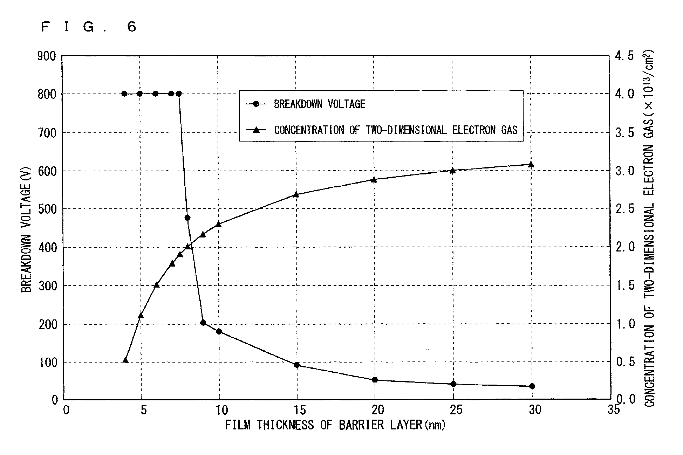

Fig. 6 is a graph showing the 2DEG concentration and breakdown voltage of the HEMT device 20 plotted against the thickness (film thickness) of the barrier layer 13. Also in this example, the measurement results of breakdown voltage showed no difference depending on the type of the gate electrode 16. Thus, Fig. 6 shows the results in the case where the gate electrode 16 was formed of a Pt/Au multilayer metal electrode.

As shown in Fig. 6, the evaluation results of the 2DEG concentration and breakdown voltage in this example in which the Si-based substrate was used as the substrate 10 were nearly the same as the results of Example 1 shown in Fig. 5. This means that in the case where the barrier layer 13 is formed of a group-III nitride having a composition of $In_{0.18}Al_{0.82}N$ on the channel layer 11 to have a thickness of 5 nm or more and 7.5 nm or less, irrespective of the type of the substrate 10, the HEMT device 20 can be obtained which has high breakdown voltage while securing 2DEG concentration.

(Example 3)

In this example, multiple types of HEMT devices 20 were produced and evaluated in the procedure similar to that of Example 2 except for that the composition and the thickness of the barrier layer 13 were varied and only the Pt/Au multilayer electrode was provided as the gate electrode 16.

To be specific, the Ga mole fraction z of the barrier layer 13 was designated as four types, 0, 0.1, 0.2, and 0.3. Any five levels of the In mole fraction x were selected from 0.08, 0.10, 0.12, 0.14, 0.16, 0.18, 0.20, and 0.22 according to the Ga mole fraction z. The thickness of the barrier layer 13 was designated as six types, 5 nm, 10 nm, 15 nm, 20 nm, 25 nm, and 30 nm. For one Ga mole fraction z, 30 types of HEMT devices were produced.

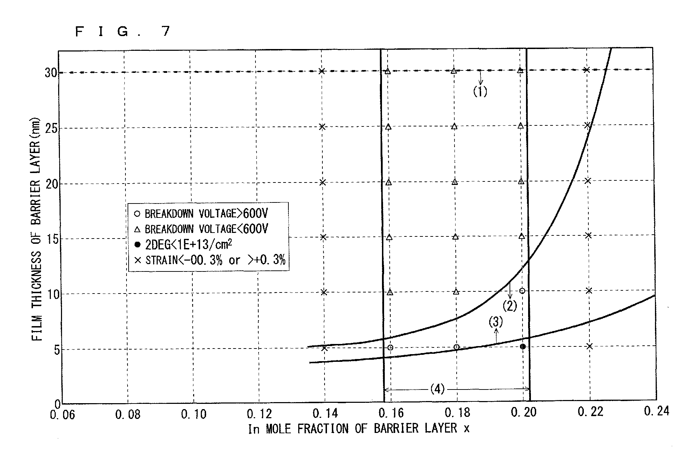

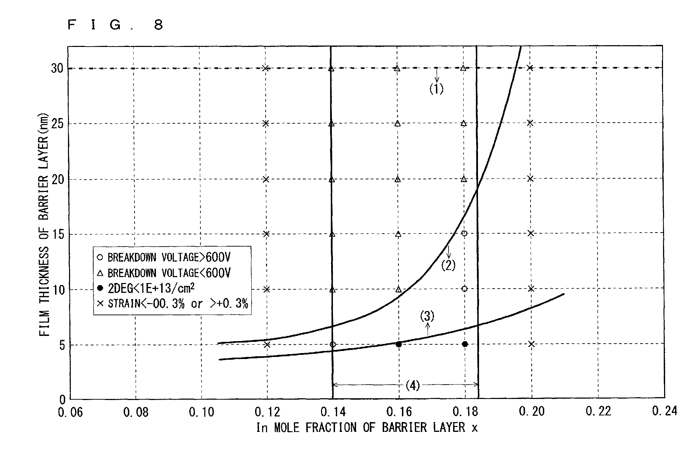

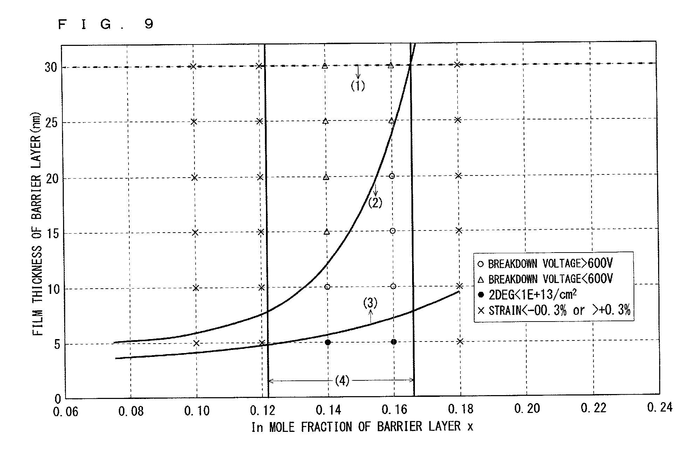

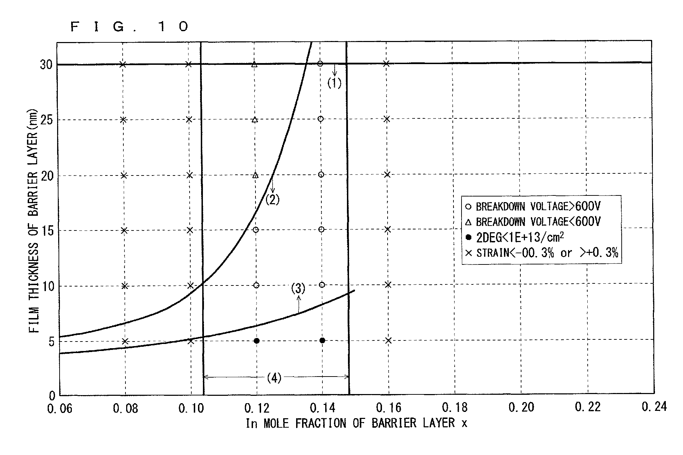

Figs. 7 to 10 are mapping diagrams showing the electrical characteristics of the HEMT device 20 in the cases where the Ga mole fraction z of the barrier layer 13 is 0, 0.1, 0.2, and 0.3, where the vertical and horizontal axes represent the In mole fraction x and the thickness (film thickness) of the barrier layer 13, respectively. Figs. 7 to 10 also show the ranges of (Expression 1) to (Expression 4).

In the drawings, ○ (open circle), Δ (white triangle), and ● (black circle) indicate the HEMT device 20 that has a breakdown voltage exceeding 600 V, the HEMT device 20 that has a breakdown voltage of less than 600 V, and the HEMT device 20 having the 2DEG concentration of less than $1.0 \times 10^{13} cm^{-2}$, respectively. Further, × indicates the HEMT device 20 which does not satisfy such a requirement that a lattice strain is within ±0.3%.

Figs. 7 to 10 show that if (Expression 1) to (Expression 4) are satisfied, a lattice-matched HEMT device 20 can be achieved, which has a 2DEG concentration of $1.0 \times 10^{13} cm^{-2}$ or more and a breakdown voltage of 600 V or more. In particular, it is shown that if $0 \leq z \leq 0.2$, the above-mentioned HEMT device 20 can be obtained by satisfying (Expression 2) to (Expression 4).

**Claims**

1. A semiconductor device comprising:

   a base substrate;
   a channel layer formed on said base substrate and made of GaN;
   a barrier layer formed on said channel layer and made of a group-III nitride having a composition of $In_xAl_yGa_zN$ ($x+y+z=1$, $0 \leq z \leq 0.3$); and
   a source electrode, a drain electrode, and a gate electrode formed on said barrier layer,
   wherein x, z, and d satisfy the ranges below

[Expression 1]

$$d \leq 30$$

[Expression 2]

$$d < 0.06\exp(48(x + 0.3z - 0.1)) + 4.8$$

[Expression 3]

$$d \geq 0.3\exp(22(x + 0.3z - 0.1)) + 3$$

[Expression 4]

$$-\frac{z - 0.875}{5.54} < x < -\frac{z - 1.123}{5.56}$$

where d represents a thickness of said barrier layer.

2. The semiconductor device according to claim 1, further comprising a spacer layer made of a group-III nitride containing at least Al between said channel layer and said barrier layer.

3. The semiconductor device according to claim 1 or 2, wherein
said substrate includes:

a Si single crystal base material;
a first base layer formed on said Si single crystal base material and made of AlN;
a second base layer formed on said first base layer and made of $Al_pGa_{1-p}N$ ($0 \leq p < 1$), and
a buffer layer formed immediately above said second base layer,

said first base layer is a layer with many crystal defects formed of at least one kind from a columnar or granular crystal or domain,
an interface between said first base layer and said second base layer is a three-dimensional concavo-convex surface, and
said channel layer is formed on said buffer layer.

4. The semiconductor device according to claim 3, wherein said buffer layer includes at least one composition modulation layer formed of a first composition layer and a second composition layer, said first composition layer being made of AlN, said second composition layer being made of a group-III nitride having a composition of $Al_{xi}Ga_{1-xi}N$ ($0 \leq x < 1$).

5. The semiconductor device according to claim 1 or 2, wherein said substrate is an AlN template substrate including an AlN buffer layer formed on a predetermined single crystal base material.

6. A method for manufacturing semiconductor device, comprising:

a substrate preparing step of preparing a base substrate;
a channel layer forming step of forming a channel layer made of GaN on said base substrate;
a barrier layer forming step of forming a barrier layer made of a group-III nitride having a composition of $In_xAl_yGa_zN$ ($x+y+z=1$, $0 \leq z \leq 0.3$) on said channel layer; and
an electrode forming step of forming a source electrode, a drain electrode, and a gate electrode on said barrier layer,
wherein in said barrier layer forming step, said barrier layer is formed such that x, z, and d satisfy the ranges below

[Expression 5]

$$d \leq 30$$

[Expression 6]

$$d < 0.06\exp(48(x + 0.3z - 0.1)) + 4.8$$

[Expression 7]

$$d \geq 0.3\exp(22(x + 0.3z - 0.1)) + 3$$

[Expression 8]

$$-\frac{z - 0.875}{5.54} < x < -\frac{z - 1.123}{5.56}$$

where d represents a thickness of said barrier layer.

7. The method for manufacturing semiconductor device according to claim 6, further comprising a spacer layer forming step of forming a spacer layer made of a group-III nitride containing at least Al on said channel layer, wherein said barrier layer is formed on said spacer layer.

8. The method for manufacturing semiconductor device according to claim 6 or 7, wherein said substrate preparing step includes:

a first base layer forming step of forming a first base layer made of AlN on a Si single crystal base material;
a second base layer forming step of forming a second base layer made of $Al_pGa_{1-p}N(0 \leq p < 1)$ on said first base layer; and
a buffer forming step of forming a buffer layer immediately above said second base layer,

in said first base layer forming step, said first base layer is formed as a layer with many crystal defects formed of at least one kind from a columnar or granular crystal or domain, a surface thereof being a three-dimensional concavo-convex surface, and
in said channel layer forming step, said channel layer is formed on said buffer layer.

9. The method for manufacturing semiconductor device according to claim 8, wherein in said buffer layer forming step, a composition modulation layer forming step of alternately laminating a first composition layer made of AlN and a second composition layer made of a group-III nitride having a composition of $Al_{xi}Ga_{1-xi}N$ ($0 \leq xi < 1$) to form one composition modulation layer is performed at least once, to thereby provide at least said one composition modulation layer on said buffer layer.

10. The method for manufacturing semiconductor device according to claim 6 or 7, wherein said substrate preparing step includes a template substrate forming step of forming an AlN buffer layer on a predetermined single crystal base material to form an AlN template substrate.

F I G .  1

20

14          16          15

13

12

11e

11

10

# F I G . 2

(a)

(b)

F I G . 3

F I G .  4

132 (132⟨n⟩)
131 (131⟨n⟩)

132 (132⟨2⟩)
131 (131⟨2⟩)
132 (132⟨1⟩)
131 (131⟨1⟩)

132 (132⟨n⟩)
131 (131⟨n⟩)

132 (132⟨2⟩)
131 (131⟨2⟩)
132 (132⟨1⟩)
131 (131⟨1⟩)

132 (132⟨n⟩)
131 (131⟨n⟩)

132 (132⟨2⟩)
131 (131⟨2⟩)
132 (132⟨1⟩)
131 (131⟨1⟩)

11
2c

10

104b

103

104a

105

103

104a

103

2b
2a
2

1

F I G . 5

FIG. 6

FIG. 7

F I G . 8

F I G . 9

FIG. 1 0

## INTERNATIONAL SEARCH REPORT

| International application No. |
| --- |
| PCT/JP2012/081363 |

**A. CLASSIFICATION OF SUBJECT MATTER**
*H01L21/338*(2006.01)i, *H01L21/205*(2006.01)i, *H01L29/778*(2006.01)i, *H01L29/812*(2006.01)i

According to International Patent Classification (IPC) or to both national classification and IPC

**B. FIELDS SEARCHED**

Minimum documentation searched (classification system followed by classification symbols)
H01L21/338, H01L21/205, H01L29/778, H01L29/812

Documentation searched other than minimum documentation to the extent that such documents are included in the fields searched
Jitsuyo Shinan Koho          1922-1996   Jitsuyo Shinan Toroku Koho    1996-2013
Kokai Jitsuyo Shinan Koho    1971-2013   Toroku Jitsuyo Shinan Koho    1994-2013

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2011-523197 A  (Picogiga International), | 1,6 |
| Y | 04 August 2011 (04.08.2011), | 2-5,7-10 |
| | entire text; all drawings | |
| | & US 2010/0258846 A1     & WO 2009/068566 A1 | |
| | & DE 112008002818 T      & FR 2924271 A1 | |
| | & KR 10-2010-0094467 A   & CN 101878533 A | |
| Y | JP 2005-268493 A  (National Institute of Information and Communications Technology), 29 September 2005 (29.09.2005), entire text; all drawings (Family: none) | 2-5,7-10 |
| Y | WO 2011/016304 A1  (NGK Insulators, Ltd.), 10 February 2011 (10.02.2011), entire text; all drawings & DE 112010003214 T      & CN 102484049 A | 3,4,8,9 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04 March, 2013 (04.03.13) | 12 March, 2013 (12.03.13) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2012/081363

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2011/102045 A1 (NGK Insulators, Ltd.), 25 August 2011 (25.08.2011), entire text; all drawings & CN 102511075 A | 3,4,8,9 |
| Y | JP 2008-140812 A (Oki Electric Industry Co., Ltd.), 19 June 2008 (19.06.2008), entire text; all drawings (Family: none) | 5,10 |
| A | JP 2007-250991 A (Nippon Telegraph and Telephone Corp.), 27 September 2007 (27.09.2007), entire text; all drawings (Family: none) | 1-10 |
| A | WO 2007/077666 A1 (NEC Corp.), 12 July 2007 (12.07.2007), entire text; all drawings & CN 101390201 A & EP 1978550 A1 & US 2009/0045438 A1 | 1-10 |

Form PCT/ISA/210 (continuation of second sheet) (July 2009)

# EP 2 819 152 A1

**INTERNATIONAL SEARCH REPORT**

| International application No. |
|---|
| PCT/JP2012/081363 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

    JP 2011-523197 A (document 1) has disclosed the semiconductor element of claim 1. Therefore, the invention of claim 1 is not novel to the document 1, and does not have a special technical feature.
    It is considered that two inventions, which are linked by respective special technical features indicated below, are involved in claims of the present application.
    Meanwhile, the invention of claim 1 having no special technical feature is classified into invention 1.
(Continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**       ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2012/081363

Continuation of Box No.III of continuation of first sheet(2)

(Invention group 1) The inventions of claims 1-5: The inventions relating to a semiconductor element

(Invention group 2) The inventions of claims 6-10: The inventions relating to a semiconductor element manufacturing method

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2011016304 A
- WO 2011102045 A
- WO 2011122322 A
- WO 2011135963 A
- WO 2011136051 A
- WO 2011136052 A
- WO 2011166496 A

### Non-patent literature cited in the description

- **TOSHIHIDE KIKKAWA.** Highly Reliable 250W High Electron Mobility Transistor Power Amplifier. *Jpn. J. Appl. Phys.,* 2005, vol. 44, 4896
- **STACIA KELLER ; YI-FENG WU ; GIACINTA PARISH ; NAIQIAN ZIANG ; JANE J. XU ; BERND P. KELLER ; STEVEN P. DENBAARS ; UMESH K. MISHRA.** Gallium Nitride Based High Power Heterojunction Field Effect Transistors: Process Development and Present Status at USCB. *IEEE Trans. Electron Devices,* 2001, vol. 48, 552
- **MEDJDOUB, J. ; F. CARLIN ; M. GONSCHOREK ; E. FELTIN ; M.A. PY ; D. DUCATTEAU ; C. GAQUIERE ; N. GRANDJEAN ; E. KOHN.** Can InAlN/GaN be an alternative to high power/high temperature AlGaN/GaN devices?. *IEEE IEDM Tech. Digest in IEEE IEDM,* 2006, 673
- **J. KUZMIK ; G. POZZOVIVO ; J.-F. CARLIN ; M. GONSCHOREK ; E. FELTIN ; N. GRANDJEAN ; G. STRASSER ; D. POGANY ; E. GORNIK.** Off-state breakdown in InAlN/AlN/GaN high electron mobility transistors. *Phys. Status Solidi,* 2009, vol. C6, S2, , S925
- **SHINICHI IWAKAMI ; OSAMU MACHIDA ; YOSHIMICHI IZAWA ; RYOHEI BABA ; MASATAKA YANAGIHARA ; TOSHIHIRO EHARA ; NOBUO KANEKO ; HIROKAZU GOTO ; AKIO IWABUCHI.** Evaluation of AlGaN/GaN Heterostructure Field-Effect Transistors on Si Substrate in Power Factor Currection Circuit. *Jpn. J. Appl. Phys.,* 2007, vol. 46, L721
- **D.W. GOTTHOLD ; S.P. GUO ; R. BIRKHAHN ; B. ALBERT ; D. FLORESCU ; B. PERES.** Time-Dependent Degradation of AlGaN/GaN Heterostructures Grown on Silicon Carbide. *J. Electron. Mater.,* 2004, vol. 33, 408